# EUROPEAN PATENT SPECIFICATION

(11) **EP 0 803 943 B1**
(45) Date of publication and mention of the grant of the patent: **29.03.2000**
(21) Application number: 97302521.6
(22) Date of filing: 14.04.1997
(51) Int. Cl.: H01S 5/02, H01S 5/10

(54) **Surface laser diode package having an optical power monitoring function**
Oberflächenemittierende Diodenlasereinheit mit optischer Leistungsüberwachung
Module laser à diode à émission de surface avec possibilité de surveillance de la puissance optique

(30) Priority: 25.04.1996 KR 9612985
(43) Date of publication of application: 29.10.1997
(73) Proprietor: Samsung Electronics Co., Ltd., Suwon City, Kyungki-do (KR)
(72) Inventor: Kim, Il, Paldal-gu, Suwon-city, Kyungki-do (KR)
(74) Representative: Chugg, David John

(56) References cited:
- WO-A-95/18479
- T.KIM ET AL.: "A single transverse mode operation of top surface emitting laser diode with a integrated photo-diode" CONFERENCE PROCEEDINGS OF THE 8TH ANNUAL MEETING OF THE IEEE LASERS AND ELECTRO-OPTICS SOCIETY (LEOS), vol. 2, 30 October 1995, pages 416-417, XP002057227
- PATENT ABSTRACTS OF JAPAN vol. 018, no. 359 (E-1574), 6 July 1994 -& JP 06 097597 A (TOSHIBA CORP), 8 April 1994,
- HAYASHI Y ET AL: "Record low-threshold index-guided InGaAs/GaAlAs vertical-cavity surface-emitting laser with a native oxide confinement structure" ELECTRONICS LETTERS, vol. 31, no. 7, 30 March 1995, pages 560-562, XP000504313

## Description

The present invention relates to a surface laser diode package having a monitor diode for monitoring an optical power of a surface laser diode.

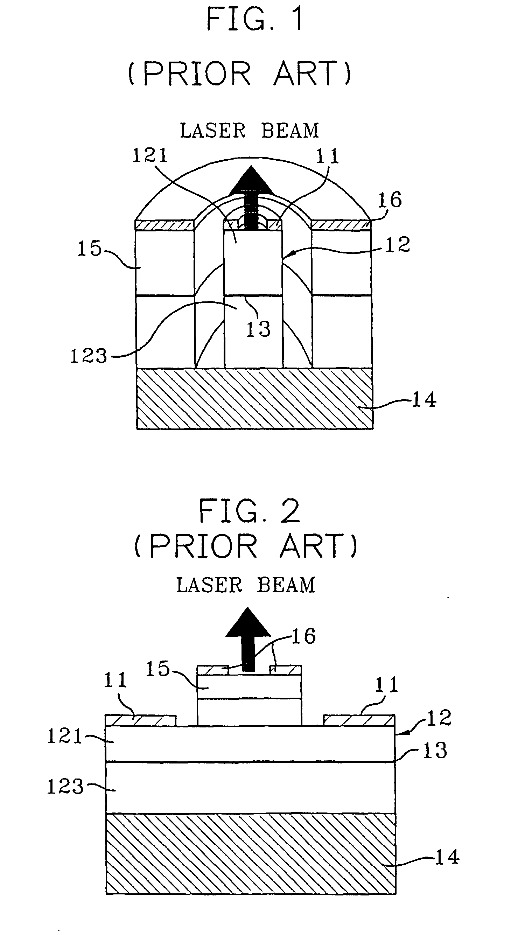

A general optical disc system such as a compact disc player projects laser light on an information recording surface of a disc and reads information recorded on the disc. In this optical disc system, if an output of the laser light varies, an error may occur when a signal is read from the disc. Thus, the optical disc system includes an automatic laser power control (ALPC) servo circuit to stably control the output of the laser light. The ALPC servo circuit includes a photodiode for monitoring an optical power of a laser diode, and keeps a driving current of the laser diode constant according to the current flowing through the photodiode. Conventional surface laser diode packages will be described below with reference to Figures 1 and 2.

In the surface laser diode package of Figure 1, a monitor diode 15 has a cylindrical shape wrapping around a surface laser diode 12. The monitor diode 15 detects a spontaneous emission beam emitted from the lateral surface of the surface laser diode 12. The detected beam is used to monitor an optical power of the surface laser diode 12. If a current is applied to an electrode 11 of the surface laser diode 12, the current is supplied to an active region 13. If the current is supplied to the active region 13, the surface laser diode 12 generates a spontaneous emission beam. If the current supplied to the active region 13 is not less than a current value necessary for laser oscillation, the spontaneous emission beam generated from the active region 13 is transformed into a surface laser beam by the laser oscillation. The beam emitted from the active region 13 oscillates in an upper mirror 121 and a lower mirror 123, and is emitted outwards via the upper mirror 121 and absorbed into a substrate 14 via the lower mirror 123. The upper mirror 121 and the lower mirror 123 interposing the active region 13 are used as a resonator. A current density should be large to generate a surface laser beam. Thus, portions outside a laser oscillation area between the upper mirror 121 and the lower mirror 123 are processed by oxidation or proton implantation to form a high ohmic layer to thereby enlarge a current density.

The spontaneous emission beam generated by the active region 13 does not completely vanish and is minutely emitted in proportion to the optical power of the surface laser diode 12. The monitor diode 15 receives the spontaneous emission beam emitted from the sides of the surface laser diode 12 when current is applied to an electrode 16 of the monitor diode 15, and outputs a monitor current in proportion to the received beam.

However, the surface laser diode package of Figure 1 is poor in terms of temperature characteristic. Thus, if temperature varies, an accurate monitor current cannot be output. Also, a spontaneous emission beam is used instead of a surface laser beam, to thereby cause an error in the optical power monitoring.

A surface laser diode package of Figure 2 has a structure where a monitor diode 15 is installed on a surface laser diode 12. The monitor diode 15 detects part of a surface laser beam emitted from the surface laser diode 12 when current is applied to an electrode 16 of the monitor diode 15. The detected beam is used for monitoring an optical power of the surface laser diode 12.

However, since the monitor diode 15 detects the spontaneous emission beam as well as the surface laser beam emitted from the surface laser diode 12, an error has occurred in the optical power monitoring. In addition, since the surface laser beam emitted to the external is used, the optical power of the surface laser diode 12 is lost and the manufacturing process becomes complicated.

A paper by T Kim, T K Kim, E K Lee, J Y Kim, and T I Kim entitled "A Single Transverse Mode Operation of Top Surface Emitting Laser Diode with a Integrated Photodiode" published under the "Conference proceedings of the 8th annual meeting of the IEEE Lasers and Electro-Optics Society, Volume II, 30 October 1995, pages 416 to 417" discloses a monitor diode comprising an i-GaAs detector layer installed between a substrate (p-GaAs) and a lower mirror (N-DBR) of a surface laser diode, for permitting a light detection operation with respect to a surface laser beam emitted towards the substrate via the lower mirror in order to monitor the optical power of the surface laser diode.

With a view to solving or reducing the above problems, it is an aim of embodiments of the present invention to provide a surface laser diode package capable of monitoring an optical power by detecting a surface laser beam except a spontaneous emission beam among beams emitted toward a substrate via a lower mirror of a surface laser diode.

According to an aspect of the present invention, there is provided a surface laser diode package having an optical power monitoring function for a surface laser beam, the surface laser diode package comprising: a substrate; a surface laser diode for making a spontaneous emission beam generated from an active region oscillate by means of an upper mirror and a lower mirror, and emitting a surface laser beam obtained by the oscillation; a monitor diode, installed between said substrate and the lower mirror of said surface laser diode, for performing a light detection operation with respect to the surface laser beam emitted toward said substrate via the lower mirror, in order to monitor the optical power of said surface laser diode; and the diode package being characterized in that there is provided a light scattering portion installed at a region of the junction surface of said monitor diode and the lower mirror of said surface laser diode which region is outside of a portion of said lower mirror corresponding to the surface from which the surface beam of said upper mirror is emitted, said light scattering portion being arranged to scatter the spontaneous emission beam incident on it via said lower mirror.

Preferably, said light scattering portion is processed by oxidation.

For a better understanding of the invention, and to show how embodiments of the same may be carried into effect, reference will now be made, by way of example, to the accompanying diagrammatic drawings, in which:
Figures 1 and 2 shows the structures of conventional surface laser diode packages; and
Figure 3 shows the structure of a surface laser diode package according to a preferred embodiment of the present invention.

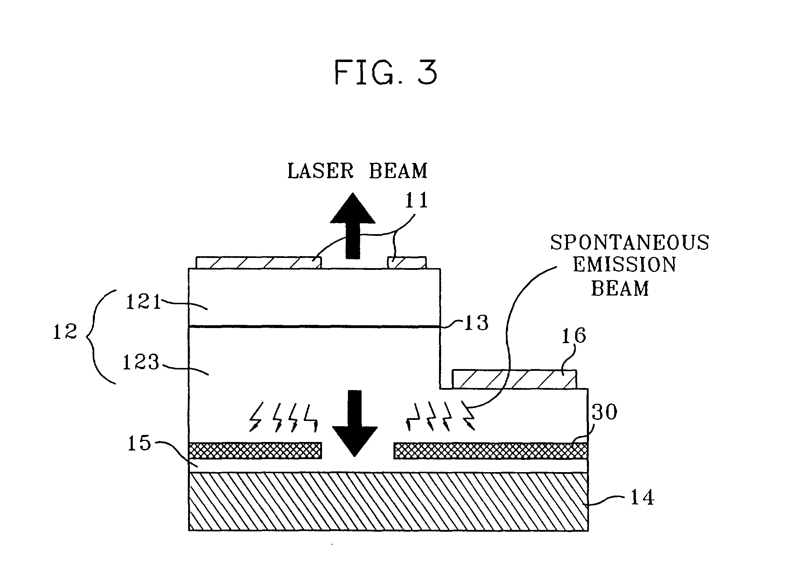

A preferred embodiment of the present invention will be described with reference to the accompanying Figure 3.

Referring to Figure 3, the present invention uses the fact that light emitted from an active region of a surface laser diode package is emitted in both the directions of an upper mirror and a lower mirror.

In the surface laser diode package of Figure 3, a monitor diode 15 performs a light detection operation with respect to a laser beam emitted toward a substrate 14 via a lower mirror 123 of the surface laser diode 12. In more detail, the monitor diode 15 is installed on a junction surface of a P-type substrate 14 and an N-type lower mirror 123 of the surface laser diode 12, and performs a light detection operation with respect to the beam emitted via the lower mirror 123. The monitor diode 15 generates a monitor current in proportion to the intensity of the incident laser beam. A reference numeral 16 represents the electrode of the monitor diode 15.

Spontaneous emission beams generated by the active region 13 are randomly emitted in various directions, part of which oscillates by the upper mirror 121 and the lower mirror 123. The spontaneous emission beam which do not oscillate by the mirrors 121 and 123 causes incorrect monitoring of the optical power of the surface laser diode 12. A light scattering portion 30 is used to avoid the detection of the spontaneous emission beam. The light scattering portion 30 is formed by an oxidation process and is installed on the surface of the lower mirror 123 except a portion from which the surface laser beam is emitted. The spontaneous emission beam incident to the light scattering portion 30 is scattered therefrom. As a result, most of the spontaneous emission beam which do not oscillate is scattered by the light scattering portion 30 constituted by the oxidation processed layer.

The surface laser beam generated by the surface laser diode 12 is incident to the monitor diode 15 via a portion where the light scattering portion 30 is absent. In this case, a little spontaneous emission beam is incident to the monitor diode 15 via the portion where the light scattering portion 30 is absent. However, since the incident spontaneous emission beam has very little intensity, the monitor current generated according to the optical power of the surface laser beam does not change. Thus, the monitor diode can output the monitor current which is proportional to the optical power of the surface laser diode 12.

As described above, the surface laser diode package having an optical power monitoring function can monitor an optical power of the surface laser diode with more accuracy.

While only certain embodiments of the invention have been specifically described herein, it will be apparent that numerous modifications may be made thereto without departing from the scope of the invention.

## Claims

1. A surface laser diode package having an optical power monitoring function for a surface laser beam, the surface laser diode package comprising:
a substrate (14);
a surface laser diode (12) for making a spontaneous emission beam generated from an active region oscillate by means of an upper mirror (121) and a lower mirror (123), and emitting a surface laser beam obtained by the oscillation;
a monitor diode (15), installed between said substrate (14) and the lower mirror (123) of said surface laser diode (12), for performing a light detection operation with respect to the surface laser beam emitted toward said substrate (14) via the lower mirror (123), in order to monitor the optical power of said surface laser diode (12); and
the diode package being characterized in that there is provided a light scattering portion (30) installed at a region of the junction surface of said monitor diode (15) and the lower mirror (123) of said surface laser diode (12) which region is outside of a portion of said lower mirror (123) corresponding to the surface from which the surface beam of said upper mirror (121) is emitted, said light scattering portion (30) being arranged to scatter the spontaneous emission beam incident on it via said lower mirror.

2. The surface laser diode package according to claim 1, wherein said light scattering portion (30) is processed by oxidation.

## Patentansprüche

1. Oberflächenemittierende Diodenlasereinheit mit einer optischen Leistungsüberwachungsfunktion für einen oberflächenemittierten Laserstrahl, wobei die oberflächenemittierende Diodenlasereinheit umfaßt:
ein Substrat (14);
eine oberflächenemittierende Laserdiode (12), damit ein spontaner Emissionsstrahl, der von einem aktiven Bereich erzeugt wird, mittels eines oberen Spiegels (121) und eines unteren Spiegels (123) schwingt und ein oberflächenemittierter Laserstrahl emittiert wird, der durch die Schwingung erhalten wird;
eine Überwachungsdiode (15), die zwischen dem Substrat (14) und dem unteren Spiegel (123) der oberflächenemittierenden Laserdiode (12) eingerichtet ist, um eine Lichterfassungsoperation in bezug auf den oberflächenemittierten Laserstrahl durchzuführen, der zu dem Substrat (14) über den unteren Spiegel (123) emittiert wird, damit die optische Leistung der oberflächenemittierenden Laserdiode (12) überwacht wird; und
wobei die Diodeneinheit **dadurch gekennzeichnet** ist, daß ein Lichtstreuabschnitt (30) vorgesehen ist, der in einem Bereich der Übergangsoberfläche der Überwachungsdiode (15) und des unteren Spiegels (123) der oberflächenemittierenden Laserdiode (12) eingerichtet ist, wobei der Bereich außerhalb eines Abschnitts des unteren Spiegels (123) ist, der der Oberfläche entspricht, von der der oberflächenemittierte Strahl des oberen Spiegels (121) emittiert wird, wobei der Lichstreuabschnitt (30) ausgebildet ist, den spontanen Emissionsstrahl, der auf ihn auftrifft, über den unteren Spiegel zu streuen.

2. Oberflächenemittierende Diodenlasereinheit gemäß Anspruch 1, wobei der Lichtstreuabschnitt (30) durch Oxidation hergestellt wird.

## Revendications

1. Module de diode laser à émission de surface ayant une fonction de contrôle de la puissance optique sur un faisceau laser à émission de surface, ledit module de diode laser à émission de surface comprenant :
un substrat (14) ;
un diode laser à émission de surface (12) pour faire osciller un faisceau d'émission spontanée généré depuis une région active au moyen d'un miroir supérieur (121) et d'un miroir inférieur (123), et émettre un faisceau laser à émission de surface obtenu par l'oscillation ;
une diode de contrôle (15) installée entre ledit substrat (14) et le miroir inférieur (123) de ladite diode laser à émission de surface (12) pour mettre en oeuvre une opération de détection de lumière par rapport au faisceau laser à émission de surface émis en direction du substrat (14) via le miroir inférieur (123), pour contrôler la puissance optique de ladite diode laser à émission de surface (12) ; et
le module à diode étant caractérisé en ce qu'il est prévu une portion dispersant la lumière (30) installée au niveau d'une région de la surface de jonction entre ladite diode de contrôle (15) et le miroir inférieur (123) de ladite diode laser à émission de surface (12), laquelle région est extérieure à une portion dudit miroir inférieur (123) correspondant à la surface depuis laquelle le faisceau à émission de surface dudit miroir supérieur (121) est émis, ladite portion dispersant la lumière (30) étant disposée de façon à disperser le faisceau d'émission spontanée qui lui est incident via ledit miroir inférieur.

2. Module de diode laser à émission de surface selon la revendication 1, dans lequel ladite portion dispersant la lumière (30) est traitée par oxydation.
